(19) Europäisches Patentamt
European Patent Office
Office européen des brevets

(11) Veröffentlichungsnummer: **0 005 750**
**B1**

(12) # EUROPÄISCHE PATENTSCHRIFT

(45) Veröffentlichungstag der Patentschrift: **03.03.82**

(51) Int. Cl.³: **G 03 F 7/10,** C 08 G 18/67, G 03 C 1/68

(21) Anmeldenummer: **79101410.3**

(22) Anmeldetag: **09.05.79**

(54) **Photopolymerisierbares Gemisch und lichtempfindliches Schichtübertragungsmaterial.**

(30) Priorität: **20.05.78 DE 2822190**

(43) Veröffentlichungstag der Anmeldung:
**12.12.79 Patentblatt 79/25**

(45) Bekanntmachung des Hinweises auf die Patenterteilung:
**03.03.82 Patentblatt 82/9**

(84) Benannte Vertragsstaaten:
**BE CH DE FR GB IT NL SE**

(56) Entgegenhaltungen:
EP - A - 0 000 890
DE - A - 2 102 382
DE - A - 2 115 373
DE - A - 2 404 239
DE - A - 2 446 056
DE - A - 2 509 842
DE - A - 2 542 314
FR - A - 2 284 623
GB - A - 1 441 108
US - A - 3 850 770
US - A - 4 078 015

(73) Patentinhaber: **HOECHST AKTIENGESELLSCHAFT**
**Postfach 80 03 20**
**D-6230 Frankfurt/Main 80 (DE)**

(72) Erfinder: **Faust, Raimund Josef, Dr. Ing. Dipl.-Chem.**
**Adolf-Todt-Strasse 5**
**D-6200 Wiesbaden (DE)**

**EP 0 005 750 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Photopolymerisierbares Gemisch und lichtempfindliches Schichtübertragungsmaterial

Die Erfindung betrifft ein photopolymerisierbares Gemisch, das polymere Bindemittel, polymerisierbare Verbindungen und Photoinitiatoren enthält.

Derartige Gemische werden in der Reproduktionstechnik zur Herstellung von Druckplatten, Photoresists, d. h. Ätz- und Galvanoreservagen, und—ggf. farbigen—Reliefbildern verwendet.

Eine besondere Gruppe derartiger Gemische, die zur Photoresistherstellung dienen, wird als trockene photopolymerisierbare Schicht auf einem temporären Schichtträger aus einer transparenten flexiblen Kunststoffolie verwendet, wobei die Schicht unter Druck und Erwärmen auf einen bildmäßig zu modifizierenden Träger aus Metall, z.B. eine Kupferplatte, laminiert, dort belichtet und zum Photoresist entwickelt wird. Die Schichten sollen bevorzugt die Eigenschaft haben, sich mit wäßrigen, normalerweise wäßrigalkalischen Entwicklerlösungen entwickeln zu lassen. Derartige Materialien und Verarbeitungsverfahren sind z.B. in der DE—AS 15 22 515 und den DE—OS 20 64 079 und 23 61 041 beschrieben.

Besonders die in den genannten Offenlegungsschriften beschriebenen Schichten zeigen bei wäßrig-alkalischer Entwicklung eine gute Haftung auf dem Träger, insbesondere auf Kupfer, und eine gute Resistenz gegenüber Atzlösungen und galvanischen Bädern.

Die hierfür erforderlichen, in wäßrig-alkalischen Lösungen löslichen, mindestens aber quellbaren Bindemittel haben häufig den Nachteil, der belichteten Schicht eine gewisse Sprödigkeit zu verleihen. Das gilt insbesondere für solche Bindemittel, die wegen ihres Gehalts an Monomereinheiten, die dem Polymerisat eine höhere Glastemperatur verleihen, zur Vermeidung des Kaltflusses der unbelichteten Schicht besonders bevorzugt werden. Derartige Bindemittel sind z.B. in der US—PS 3 930 865 beschrieben.

Auch Monomere mit mehr als zwei polymerisierbaren Gruppen im Molekül, die wegen der hohen Vernetzungsdichte ihrer Belichtungsprodukte an sich besonders vorteilhaft sind, führen in der Regel zu Belichtungsprodukten, die relativ spröde sind, insbesondere wenn die Belichtung über das optimale Maß hinaus ausgedehnt wird.

Als Monomere oder polymerisierbaren Verbindungen, die mit diesen Bindemitteln gut verträglich sind und andere für die Photoresisttechnik vorteilhafte Eigenschaften haben, haben sich besonders bestimmte Verbindungen mit Urethangruppen im Molekül bewährt. Derartige polymerisierbare Verbindungen sind in den oben genannten DE—OS beschrieben. Die Verbindungen der DE—OS 20 64 079, die stets zwei Urethangruppen im Molekül enthalten, ergeben infolge ihrer größeren Zahl an Acrylestergruppen oder ihres relativ niedrigen Molekulargewichts eine hohe Vernetzungsdichte und damit Schichten, die nach der Belichtung zur Versprödung neigen. Diejenigen Vertreter die ein höheres Molekulargewicht haben, ergeben Schichten, die zu geringerer Lichtempfindlichkeit und schlechterer Entwicklerresistenz neigen.

Die Verbindungen der DE—OS 23 61 041, die Biuretgruppen enthalten, weisen ebenfalls eine Tendenz zur Bildung relativ spröder Belichtungsprokukte auf. Die dort weiterhin beschriebenen Verbindungen mit vier Urethangruppen und einer Polyäthergruppe im Molekül sind wiederum den genannten Verbindungen mit zwei Urethangruppen noch recht ähnlich.

Man kann generell sagen, daß photopolymerisierbare Schichten, deren Kaltfluß im unbelichteten Zustand genügend klein ist, und die nach der Belichtung eine gute Haftung am Trägermetall, eine gute Entwicklerresistenz und Beständigkeit gegen Atzlösungen und galvanische Bäder aufweisen, verhältnismäßig spröde Belichtungsprodukte bilden. Das gilt besonders bei Überbelichtungen, d.h. es verbleibt für die Verarbeitung derartiger Schichten in der Regel nur ein sehr geringer Belichtungsspielraum, wenn man eine optimale Kombination von Eigenschaften erreichen will. Ein weiteres Verspröden kann schließlich auch beim Lagern oder Handhaben der Produkte bei Tageslicht eintreten.

Durch die erhöhte Sprödigkeit der belichteten und auch der unbelichteten Photoresistschicht treten bei der Weiterverarbeitung, z.B. der Herstellung gedruckter Schaltungen, erhebliche Schwierigkeiten auf. Diese Schwierigkeiten bestehen darin, daß beim Beschneiden der mit dem Trockenresist kaschierten Kupferleiterplatten die spröde Resistschicht zur Bildung von Flittern neigt, die eine erhebliche Verschmutzung und Störung bei der Weiterverarbeitung zur Folge haben können. Zum anderen brechen die spröden Resistüberhänge beim Ätzen in den üblichen Sprühätzmaschinen leicht ab, oder es kommt zum Abplatzen feinerer Details der Photomasken in ungünstigen Galvanobädern, insbesondere bei Goldbädern, bei denen die Stromausbeute relativ gering ist (z.B., 45% bis herab zu 25%). Hierbei verursacht der entstehende Wasserstoff leicht ein Abplatzen von spröden Resistmasken.

Für andere Zwecke, d. h. für die Herstellung von Flexodruckplatten, sind in der DE—AS 21 15 373 polymerisierbare höhermolekulare Polyurethanverbindungen beschrieben, die Polyätherblöcke mit mindestens 5, vorzugsweise 9 bis 10 Ätherbindungen, enthalten. Diese Verbindungen werden nicht in Kombination mit hochpolymeren Bindemitteln beschrieben. Wenn sie mit solchen zu festen lichtempfindlichen Schichten kombiniert werden, weisen diese bei der zu einer ausreichenden Vernetzung erforderlichen Konzentration an polymerisierbarer Verbindung eine Neigung zum Kaltfluß auf. Weiterhin haben derartige Schichten im belichteten Zustand den Nachteil, daß bei ihnen die Abscheidung von Kupfer aus sauren galvanischen Kupferbädern bis zu einem Abstand von etwa 50 μm und mehr von den Resistlinien gestört wird, d. h. an feinen Leiterbahnen eines Schaltbilds wird kein Kupfer abgeschieden. Dieser Typ von polymerisierbaren Polyurethanen ist deshalb für die Photoresistherstellung nicht geeignet.

In der US—PS 3 850 770 sind Urethanmonomere beschrieben, die in Kombination mit alkalilöslichen Bindemitteln flexible photopolymerisierbare Schichten ergeben, die zur Herstellung von Druckplatten dienen. Auch diese Urethane enthalten Polyäthersequenzen mit 3 bis 45, vorzugsweise 8 bis 10 Ätherbindungen. Die Verbindungen enthalten jeweils vier Urethangruppen, und es wird angegeben, daß ein zu hoher Gehalt an Urethangruppen je Molekulargewichtseinheit diese Verbindungen für den vorgesehenen Zweck unbrauchbar macht.

Aufgabe der Erfindung war es, neue Urethangruppen enthaltende photopolymerisierbare Verbindungen anzugeben, die sich mit alkalilöslichen bzw. in wäßrigem Alkali quellbaren Bindemitteln zu photopolymerisierbaren Schichten kombinieren lassen, die geringen oder gar keinen Kaltfluß aufweisen und die Belichtungsprodukte mit hoher Vernetzungsdichte und damit hoher Entwickler-, Ätz- und Galvanoresistenz sowie guter Haftung auf metallischen Trägern, insbesondere auf Kupfer, ergeben, die auch bei beträchtlicher Überbelichtung noch flexibel sind und im übrigen alle für die Herstellung von Photoresists erforderlichen Eigenschaften haben.

Die Erfindung geht aus von einem photopolymerisierbaren Gemisch, das ein polymeres, in wäßrig-alkalischen Lösungen lösliches oder mindestens quellbares Bindemittel, einen Photoinitiator und ein zur Additionspolymerisation befähigtes Polyurethan mit zwei Acryl- oder Methacrylsäureestergruppen im Molekül enthält.

Das erfindungsgemäße Gemisch ist dadurch gekennzeichnet, daß es ein Polyurethan der Formel I

$$CH_2=\underset{R_1}{C}—COO—Z—CONH—Y—(NHCOO—X—CONH—Y—)_nNHCOO—Z—CO—\underset{R_1}{C}=CH_2 \qquad (I)$$

enthält, worin

—X— eine der Gruppen

$$(—CH_2—\underset{R_2}{CH}—O)_m— , \quad (—CH_2—\underset{R_2}{CH}—S—)_{m-1}CH_2\underset{R_2}{CH}—O— , \quad —C_kH_{2k}—O— \text{ und } —C_rH_{2r-2}—O— ,$$

Y ein gesättigter aliphatischer oder cycloaliphatischer Rest mit 2 bis 12 Kohlenstoffatomen,

Z

$$(—CH_2—\underset{R_3}{CH}—O)_p ,$$

$R_1$, $R_2$ und $R_3$ Wasserstoffatome oder Methylgruppen,
n eine Zahl von 2 bis 15,
m eine Zahl von 2 bis 4,
p eine Zahl von 1 bis 4,
k eine Zahl von 2 bis 12,
r eine Zahl von 4 bis 12
ist.

Die erfindungsgemäßen Gemische enthalten im allgemeinen 10 bis 60 Gew.-%, vorzugsweise 15 bis 35 Gew.-%, bezogen auf ihre nichtflüchtigen Bestandteile, an Verbindungen der Formel I.

Die Verbindungen enthalten im Mittel mindestens 6 Urethangruppen im Molekül, d. h. mindestens 3 Urethangruppen je Doppelbindung. Ihre mittleren Molekulargewichte liegen im allgemeinen zwischen 800 und 10000, vorzugsweise bei 1000 bis 7000. Die Viskosität der niedermolekularen Vertreter soll mindestens $10^5$mPa.s betragen, die höhermolekularen Vertreter sind fest.

Von den Verbindungen der Formel I werden diejenigen mit n = 2 bis 11, insbesondere 3 bis 7, bevorzugt. Verbindungen mit n = 2 bis 4 sind geeignet, als einzige polymerisierbare Verbindungen in dem Gemisch verwendet zu werden. Verbindungen, in denen n = 5 oder größer ist, werden vorzugsweise mit niedermolekularen Urethanen kombiniert. Hierfür sind sowohl die Vertreter mit n = 2 bis 4 als auch die aus der DE—OS 20 64 079 bekannten Diurethane aus 1 Mol Diisocyanat und 2 Molen Hydroxyalkylmethacrylat oder -acrylat sowie die aus der DE—OS 23 61 041 bekannten Tetraurethane aus 1 Mol Diol bzw. Polyätherdiol, 2 Molen Diisocyanat und 2 Molen Hydroxyalkylmethacrylat oder -acrylat geeignet. Je nach dem Molekulargewicht des höhermolekularen Polyurethans kann die Menge des niedermolekularen Urethans bis zu 70 Gew.-%, bevorzugt 20 bis 55 Gew.-% der Gesamtmenge an polymerisierbaren Urethanen betragen.

Die Verbindungen der Formel I können als reine Verbindungen mit einem genau definierten einheitlichen Wert für n vorliegen. In der Praxis werden sie zumeist entsprechend ihrem weiter unten angegebenen Herstellungsverfahren als Homologengemische vorliegen, deren Molekulargewichte und

deren Werte für n um einen mittleren Wert verteilt sind. Wenn im Folgenden von bestimmten Werten für n oder z.B. von Tetraurethanen die Rede ist, sollen dabei stets solche Homologengemische mitumfaßt sein, deren entsprechende Werte Mittelwerte sind und in erster Näherung dem angegebenen Wert entsprechen, Die Mittelwerte für n bzw. für die Molekulargewichte lassen sich dabei auch ohne genaue Ermittlung des Molekulargewichts des erhaltenen Produkts in für die Praxis ausreichender Genauigkeit aus der Menge der eingesetzten Reaktionsteilnehmer errechnen.

Der Diolrest X in der allgemeinen Formel I kann von einem gesättigten oder einfach ungesättigten Diol abgeleitet sein. Als gesättigte Diole sind lineare und verzweigte Verbindungen mit 2 bis 12 Kohlenstoffatomen, vorzugsweise 4 bis 12 Kohlenstoffatomen, geeignet.

Beispiele für geeignete Diole sind Äthylenglykol, Propylenglykol, Butandiol-(1,4), But-2-endiol-(1,4), 2-Äthyl-hexandiol-(1,6), Decandiol-(1,10) und 1,4-Bis-hydroxymethyl-cyclohexan.

Der Diolrest X kann ferner in seiner Kette Sauerstoff- oder Schwefelatome enthalten. Bevorzugt werden Reste von Polyglykolen, insbesondere Polyäthylenglykolen, mit 1 bis 3 Ätherbindungen. Triäthylenglykole werden als Diolkomponente besonders bevorzugt.

Die Gruppe Y, die sich von dem zur Herstellung verwendeten Diisocyanat ableitet, ist eine gesättigte aliphatische oder cycloaliphatische Gruppe mit 2 bis 12, vorzugsweise 6 bis 12 Kohlenstoffatomen. Bevorzugt werden acyclische aliphatische Diisocyanate, insbesondere solche mit mindestens einer seitenständigen Methylgruppe. Dabei ist das 2,2,4-Trimethyl-hexamethylendiisocyanat ein besonders bevorzugter Vertreter.

$R_1$ ist vorzugsweise eine Methylgruppe, $R_3$ ebenso wie $R_2$ bevorzugt ein Wasserstoffatom, p ist bevorzugt 1.

Die Herstellung der neuen polymerisierbaren Polyurethane erfolgt normalerweise in zwei Stufen. Zuerst wird die Diolkomponente HO—X—OH mit dem gewünschten Überschuß an Diisocyanat OCN—Y—NCO umgesetzt. Wenn man 3 Mole Diisocyanat mit 2 Molen Diol umsetzt, so erhält man ein Zwischenprodukt mit 2 endständigen Isocyanatgruppen, das im Mittel 3 Diisocyanat- und 2 Dioleinheiten enthält, also eine Verbindung mit $n = 2$. Wie oben erwähnt, entsprechen derartige Reaktionsprodukte in der Regel nicht der theroretischen Idealzusammensetzung. Durch gelchromatographische Analysen ergibt sich, daß zumeist Mischungen aus niedermolekularen und beträchtlich höhermolekularen Polyurethanen vorliegen. Die endständigen Isocyanatgruppen werden dann mit dem gewünschten Hydroxyalkylacrylat oder -methacrylat umgesetzt. Bei diesem Verfahren werden in der Regel polymerhomologe Gemische erhalten, d. h. Gemische von Verbindungen mit unterschiedlichem n. Das gilt insbesondere bei den Vertretern mit höheren mittleren Werten für n. Diese Gemische sind für die Zwecke der Erfindung hervorragend geeignet und können unmittelbar eingesetzt werden. Wenn man Produkte mit genauer definiertem oder zumindest weniger streuendem Molekulargewicht erhalten will, kann man das genannte Diisocyanat-Zwischenprodukt auch stufenweise durch Umsetzen von 1 Mol Diol mit 2 Molen Diisocyanat, Umsetzen des Reaktionsprodukts mit 2 Molen Diol usw. herstellen.

Wie bereits erwähnt, können die erfindungsgemäßen Gemische außer den genannten Polyurethanen auch einen gewissen Anteil an bekannten polymerisierbaren Di- oder Tetraurethanen enthalten. Hierfür werden bevorzugt Reaktionsprodukte aus 1 Mol eines der oben genannten Diisocyanate und 2 Mol Hydroxyalkylacrylat, vorzugsweise Hydroxyalkylmethacrylat, als Diurethane und Reaktionsprodukte aus 1 Mol Diol, vorzugsweise Triäthylenglykol, 2 Mol des entsprechenden Diisocyanats und 2 Mol Hydroxyalkylacrylat bzw. -methacrylat als Tetraurethane verwendet. Es ist auch möglich, andere Acryl- oder Methacrylsäureester, die keine Urethangruppen enthalten, in kleiner Menge, z. B. bis zu 10% der Monomermenge, zuzusetzen, doch werden bevorzugt nur Urethanmonomere verwendet.

Die erfindungsgemäßen Gemische ergeben photopolymerisierbare Schichten mit hoher Lichtempfindlichkeit, hoher Flexibilität, aber geringer oder keiner Neigung zum Kaltfluß. Die Belichtungsprodukte zeichnen sich durch hohe Flexibilität und Resistenz gegen wäßrig-alkalische Entwicklerlösungen sowie gegenüber Ätzlösungen und galvanischen Bädern aus. Sie weisen im übrigen alle Vorzüge der bekannten Gemische auf der Basis von alkalilöslichen Bindemitteln und Urethangruppen enthaltenden Monomeren auf. Es ist besonders überraschend, daß es durch Verwendung der neuen Urethanmonomeren möglich ist, im Vergleich zu Schichten mit bekannten Urethanmonomeren sowohl den Kaltfluß der unbelichteten Schicht zu verringern als auch die Flexibilität der Belichtungsprodukte zu erhöhen. Die gewünschte Kombination von schwer miteinander zu vereinbarenden Eigenschaften bleibt auch bei erheblicher Überbelichtung der Schicht erhalten, so daß dem Verbraucher die kostspielige und mühsame Aufgabe erspart bleibt, für jede Vorlage und Belichtung die optimale Belichtungszeit genau zu ermitteln.

Die erfindungsgemäßen photopolymerisierbaren Gemische enthalten ferner polymere, vorzugsweise thermoplastische, in wäßrig-alkalischen Lösungen lösliche oder mindestens quellbare Bindemittel. Derartige Polymere enthalten Gruppen, die im alkalischen Medium Salze bilden, z. B. COOH, $PO_3H_2$, $SO_3NH_2$, $SO_2NHCO$ oder OH-Gruppen. Bevorzugt werden Polymer mit Carboxylgruppen. Geeignete Bindemittel sind Maleinatharze, Polymerisate aus N-(p-Toluolsulfonyl)-carbaminsäure-($\beta$-methacryloyloxy)-äthylester und Mischpolymerisate derartiger Monomerer, Styrol-Maleinsäureanhydrid-Mischpolymerisate und insbesondere Mischpolymerisate von Acryl- und Methacrylsäure. Die letzteren können als Comonomere Alkylacrylate und -methacrylate, woven mindestens ein Teil Alkylgruppen mit 4 bis 15 C-Atomen hat, und zusätzlich zu diesen Styrol, ein substituiertes Styrol,

Acrylnitril, Benzylacrylat oder ein ähnliches Monomeres enthalten, das ein Homopolymerisat mit einer Glastemperatur Tg von mindestens 80°C bildet. Derartige bevorzugte Bindemittel sind in den US—PS 3 804 631 und 3 930 865 beschrieben. Das Bindemittel soll ein mittleres Molekulargewicht von mindestens 10000, vorzugsweise von etwa 20000 bis 200000 haben. Die Säurezahl beträgt im allgemeinen 50 bis 250, vorzugsweise 100 bis 200. Besonders bevorzugt werden Terpolymerisate aus Methacrylsäure, einem Alkylmethacrylat mit 4 bis 12 C-Atomen im Alkylrest und Styrol oder einem substituierten Styrol. Die Menge der Bindemittel beträgt im allgemeinen 20—80, bevorzugt 35—65 Gew.-% der nichtflüchtigen Bestandteile des Gemischs.

Die erfindungsgemäßen Gemische können ferner mit Vorteil bestimmte Weichmacher enthalten, die die Flexibilität der Schichten nach der Belichtung zusätzlich zur Wirkung der Monomeren wesentlich verbessern. Diese Weichmacher sind im einzelnen in der gleichzeitig eingereichten Patentanmeldung P 28 22 191 beschrieben. Sie sind Verbindungen der Formel II

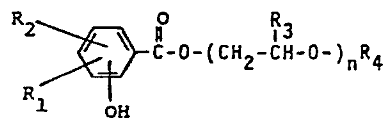

(II)

worin

$R_1$ ein Wasserstoff- oder Halogenatom oder ein Alkylrest mit 1 bis 4 Kohlenstoffatomen,
$R_2$ ein Wasserstoffatom, eine OH-Gruppe oder ein Alkylrest mit 1—4 Kohlenstoffatomen,
$R_3$ ein Wasserstoffatom oder eine Methylgruppe,
$R_4$ einen Alkyl- oder Alkenylrest mit 1 bis 20 C-Atomen und
n Null oder Zahl von 1 bis 20 bedeutet,

wobei $R_4$ mindestens 4 C-Atome hat, wenn n Null oder 1 ist.

Als Photoinitiatoren können eine Vielzahl von Substanzen Verwendung finden. Beispiele sind Benzoin, Benzoinäther, Mehrkernchinone, z. B. 2-Äthyl-anthrachinon, Acridinderivate, z. B. 9-Phenyl-acridin, 9-p-Methoxyphenyl-acridin, 9-Acetylamino-acridin, Benz(a)acridin, Phenazinderivate, z. B. 9,10-Dimethyl-benz(a)-phenazin, 9-Methyl-benz(a)phenazin, 10-Methoxy-benz(a)phenazin, Chinoxalinderivate, z.B. 6,4',4''-Trimethoxy-2,3-diphenyl-chinoxalin, 4',4''-Dimethoxy-2,3-diphenyl-5-aza-chinoxalin, Chinazolinderivate und dergl. mehr. Ihre Menge beträgt im allgemeinen 0,1 bis 10 Gew.-% der nichtflüchtigen Bestandteile des Gemisches.

Das erfindungsgemäße Gemisch kann außer Monomeren, Weichmachern, Photoinitiatoren und Bindemitteln noch eine Reihe weiterer üblicher Zusätze enthalten, z.B. Inhibitoren zur Verhinderung der thermischen Polymerisation der Monomeren, Haftvermittler, Wasserstoffdonatoren, sensitometrische Regler, Farbstoffe, Farbpigmente, ungefärbte Pigmente, Farbbildner und Indikatoren.

Diese Bestandteile sind zweckmä!ig so auszuwählen, daß sie in dem für den Initiierungsvorgang wichtigen aktinischen Wellenlängenbereich möglichst nicht zu stark absorbieren.

Das erfindungsgemäße photopolymerisierbare Gemisch kann in bekannter Weise als Lösung oder Dispersion in den Handel gebracht werden, die vom Verbraucher insbesondere zur Herstellung von Ätzschutzschichten verwendet wird. Ein bevorzugtes Anwendungsgebiet für die erfindungsgemäßen Gemische sind Trockenresistfolien, die aus einer auf einem temporären Träger, z.B. einer transparenten Kunststoffolie, befindlichen fertigen Photoresistschicht bestehen und die von Verbraucher auf die bildmäßig zu ätzende oder zu galvanisierende Unterlage kaschiert werden und dort belichtet und entwickelt werden, wobei vor dem Entwickeln der temporäre Träger entfernt wird.

Das erfindungsgemäß Gemisch eignet sich besonders gut für diese Anwendungsform. Es kann aber auch in Form eines vorsensibilisierten Kopiermaterials auf einem geeigneten Träger, z.B. auf Aluminium oder Zink, für die photomechanische Herstellung von Offset- oder Hochdruckformen fabrikmäßig hergestellt werden. Es ist ferner zur Herstellung von Reliefbildern, Siebdruckschablonen, Farbprüffolien und dergl. geeignet. Seine Vorteile kommen in allen den Fällen zur Geltung, wo es auf gute und dauerhafte Flexibilität der belichteten Schicht bei geringem Kalfluß der unbelichteten Schicht sowie hohe Resistenz der belichteten Schicht gegen aggressive Chemikalien ankommt.

Die Herstellung der lichtempfindlichen Materialien unter Verwendung des erfindungsgemäßen Gemisches erfolgt in bekannter Weise. So kann man die Mischung in einem Lösungsmittelk aufnehmen und die Lösung bzw. Dispersion durch Gießen, Sprühen, Tauchen, Antragen mit Walzen usw. auf den vorgesehenen Träger als Film aufbringen und anschließend trocknen. Dicke Schichten (z.B. von 250 µm und darüber) kann man auch durch Extrudieren oder Verpressen als selbsttragende Folie herstellen, welche dann auf den Träger laminiert wird.

Als Träger für die zu Kopierschichten verarbeiteten Gemische kommen Metalle, z. B. Aluminium, Zink, Kupfer, Stahl, Chrom, Messing und andere Metallegierungen; Siebdruckschablonenträger, z.B. aus Nickel oder Perlongaze; und Kunststoffolien in Frage, wobei die Kunststoffolien, z.B. Polyesterfolien, speziell oberflächenbehandelt sein können.

Die Kopierschichten werden in bekannter Weise belichtet und entwickelt. Als Entwickler sind wäßrige, vorzugsweise wäßrigalkalische Lösungen, z. B. von Alkaliphosphaten oder Alkalisilikaten, geeignet, denen gegebenenfalls kleine Mengen, z. B. bis zu 10, vorzugsweise weniger als 5, Gew.-% an

wassermischbaren organischen Lösungsmitteln oder auch Netzmittel zugesetzt werden können. Die Entwicklung kann von Hand oder in handelsüblichen Sprüh- oder Bürstentwicklungsgeräten erfolgen.

Die erfindungsgemäßen Gemische lassen sich, wie oben erwähnt, für die verschiedensten Anwendungsgebiete einsetzen. Mit besonderem Vorteil werden sie zur Herstellung von Photoresist- bzw. Ätzschutzschichten auf metallischen Trägern verwendet. Vor allem sind sie zur Anwendung auf Trägern aus Kupfer geeignet. Die ausgezeichnete Haftung und Flexibilität der belichteten Schichtteile bewährt sich bei diesen bevorzugten Anwendungsformen nicht nur während der Entwicklung, sondern auch während einer nachfolgenden Ätzung des Trägers, bei der die Schichten eine gute Flexibilität und Ätzresistenz zeigen.

Die Gemische lassen sich besonders gut in der Form sogenannter Trockenresistmaterialien, wie sie oben erwähnt wurden, einsetzen und handhaben, da sie sich auch trocken zu gut haftenden Schichten auf Metallträger übertragen lassen. In diesme Fall sind als temporäre Trägerfolien besonders Polyesterfolien geeignet.

Die folgenden Beispiele erläutern einzelne Ausführungsformen des erfindungsgemäßen Gemischs. Wenn nichts anderes angegeben ist, sind Prozentzahlen und Mengenverhältnisse in Gewichtseinheiten zu verstehen.

Beispiel 1

Eine Lösung aus:

6,5 g eines Terpolymerisats aus n-Hexylmethacrylat, Methacrylsäure und Styrol (60:30:10 Gew.-Teile) mit einem mittleren Molgewicht von ca. 35000,

2,8 g eines polymerisierbaren Diurethans, das durch Umsetzung von 1 Mol 2,2,4-Trimethylhexamethylendiisocyanat mit 2 Molen Hydroxyäthylmethacrylat erhalten wurde,

2.8 g des uten beschriebenen polymerisierbaren Polyurethans,

0,2 g 9-Phenyl-acridin,

0,1 g 3-Mercapto-propionsäure-2,4-dichlor-anilid,

0,035 g eines blauen Azofarbstoffs erhalten durch Kuppeln von 2,4-Dinitro-6-chlor-benzoldiazoniumsalz mit 2-Methoxy-5-acetylamino-N-cyanoäthyl-N-hydroxyäthylanilin und

2,8 g 4-Hydroxy-benzoesäure-(2-äthyl-hexyl)ester in 35 g Methyläthylketon und 2 g Äthanol.

wird auf eine biaxial verstreckte und thermofixierte Polyäthylenterephthalatfolie der Stärke 25 $\mu m$ so aufgeschleudert, daß nach dem Trocknen bei 100°C ein Schichtgewicht von 28 $g/m^2$ erhalten wird.

Man erhält eine Trockenresistfolie, die mit einer handelsüblichen Laminiervorrichtung bei 120°C auf eine mit 35 $\mu m$ starker Kupferfolie kaschierte Phenoplast-Schichtstoffplatte laminiert und 8 Sekunden mit einem handelsüblichen Belichtungsgerät belichtet wird. Als Vorlage dient eine Strichvorlage mit Linienbreiten und Abständen bis herab zu 80 $\mu m$.

Nach der Belichtung wird die Polyesterfolie abgezogen und die Schicht in einer 0,8 %igen $Na_2CO_3$-Lösung in einem Sprühentwicklungsgerät 50 Sekunden lang entwickelt.

Die Platte wird dann 30 Sekunden mit Leitungswasser gespült, 1 Minute in einer 25 %igen Ammoniumperoxydisulfat-Lösung angeätzt und sodann nacheinander in den folgenden Elektrolytbädern galvanisiert:

1.) 40 Minuten in einem Kupferelektrolytbad der Firma Blasberg, Solingen, Typ "Feinkornkupferplastic-Bad"
Stromdichte: 2 $A/dm^2$
Metallaufbau: ca. 20 $\mu m$

2.) 10 Minuten in einem Nickelbad Typ "Norma" der Firma Blasberg, Solingen
Stromdichte: 4 $A/dm^2$
Metallaufbau: 6 $\mu m$
und

3.) 15 Minuten in einem Goldbad Typ "Autronex N" der Firma Blasberg, Solingen
Stromdichte: 0,6 $A/dm^2$
Metallaufbau: 2,5 $\mu m$

Die Platte zeigt keinerlei Unterwanderungen oder Beschädigungen.

Die platte kann sodann in 5%iger KOH%Lösung bei 50°C entschichtet und das freigelegte Kupfer in den üblichen Ätzmedien weggeätzt werden.

Die oben beschriebene Trockenresistfolie ist auch bei 10-facher Oberbelichtung, also auch noch nach 80 Sekunden Belichtungszeit mit dem oben beschriebenen Belichtungsgerät, völlig flexibel. Dies kann man zeigen, wenn man einen etwa 2 cm breiten und 20 cm langen Streifen aus Trägerfolie und Schicht im belichteten Zustand mit der Hand dehnt. Hierbei läßt sich der 10-fach überbelichtete Trockenresiststreifen ohne Platzen oder Reißen der Schicht auf mindestens das Doppelte der Länge bei Zimmertemperatur verstrecken.

Diese Flexibilität ist in vielen Verarbeitungsschritten, wie Beschneiden nach dem Laminieren, Ätzen und Galvanisieren in Goldbädern u.a. von ausschlaggebendem Vorteil. Die oben beschriebene Trockenresistfolie hat ferner einen sehr geringen Kaltfluß im unbelichteten Zustand, der das Lagern von Rollen auch über lange Zeit ohne Ausquellen der Resistschicht an den Rändern ermöglicht.

Die oben beschriebene Schicht erlaubt Linien der Breite 50 $\mu m$ kantenscharf aufzulösen, dies

kann leicht durch Belichtung durch eine Auflösungstestvorlage und Entwicklung mit 0,8 %iger $Na_2CO_3$-Lösung nachgewiesen werden. Die Entwicklerresistenz beträgt mindestens das Fünffache der Entwicklungszeit.

*Synthese des Polyurethans*

In einem Dreihalskolben mit Rührer, Rückflußkühler mit aufgesetztem $CaCl_2$-Trockenrohr und Tropftrichter werden 11 Mole 2,2,4-Trimethyl-hexamethylendiisocyanat in 4,5 kg Methyläthylketon vorgelegt. Nach Zugabe einer als Katalysator wirkenden Mischung aus

1,5 g Eisen(III) acetylacetonat und
2,0 g Diäthylcyclohexylamin in
50,0 tg Methyläthylketon

werden 10 Mole wasserfreies Triäthylenglykol, gelöst in 500 g Methyläthylketon, so zudosiert, daß die Reaktionstemperatur konstant auf 70 ± 1°C gehalten wird. Hierzu wird von außen durch ein Wasserbad, das zunächst eine Temperatur von 60°C hat, erwärmt und—nach Erreichung der gewünschten Innentemperatur durch die Reaktionswärme der Polyadditionsreaktion—gekühlt (Badtemperatur: ca. 40 bis 50°C). Nach Ende der Zugabe des Triäthylenglykols werden 15 g p-Benzochinon zugegeben. Sodann werden 2 Mole Hydroxyäthylmethacrylat bei 70°C zugetropft. Nach Ende der Reaktion wird noch 2 Std. bei 70°C gerührt, dann werden 30 g Hydrochinonmonomethyläther zugegeben und die Lösung wird abgekühlt. Das so erhaltene Polyurethan kann in Lösung oder nach Abdestillieren des Lösungsmittels als Harz in den photomerisierbaren Gemischen verwendet werden; in de Beispielen wurden die Polyurethane jeweils als Harz eingesetzt.

Beispiel 2

Statt des in Beispiel 1 beschriebenen ungesättigten Polyurethans kann auch in gleicher Menge (2,8 g) ein Polyurethan verwendet werden, das in analoger Weise aus

11 Molen 2,2,4-Trimethyl-hexamethylendiisocyanat und
10 Molen Buten-2-diol-1,4 (1. Reaktionsstufe) und danach
2 Molen Hydroxyäthylmethacrylat (2. Reaktionsstufe)

hergestellt wurde.

Nach analoger Verarbeitung zu einer Trockenresistfolie mit einem Schichtgewicht von 34 $g/m^2$ wird eine auch bei 5-facher Überbelichtung noch dehnbare und flexible Resistschicht erhalten. Die Galvanoresistenzen in den in Beispiel 1 an gegebenen Elektrolytbädern sind ausgezeichnet.

Beispiel 3

Statt des in Beispiel 1 beschriebenen Polyurethans kann auch in gleicher Menge (2,8 g) ein Polyurethan verwendet werden, das in analoger Weise aus

11 Molen 2,2,4-Trimethyl-hexamethylendiisocyanat und
10 Molen Thiodipropylenglykol (1. Reaktionsstufe) und danach
2 Molen Hydroxyäthylmethacrylat (2. Reaktionsstufe)

synthetisiert wurde.

Die Prüfung im einer Trockenresistfolie mit einem Schichtgewicht von 30 $g/m^2$ ergibt ähnlich gute Eigenschaften hinsichtlich Galvanoresistenz und Flexibilität der Resistfolie.

Beispiel 4

Statt des in Beispiel 1 beschriebenen Polyurethans kann auch in gleicher Menge (2,8 g) ein Polyurethan verwendet werden, das in analoger Weise aus

11 Molen 2,2,4-Trimethyl-hexamethylendiisocyanat und einem Gemisch von
5 Molen Triäthylenglykol und
5 Molen Thiodiglykol (1. Reaktionsstufe) und danach
2 Molen Hydroxyäthylmethacrylat (2. Reaktionsstufe)

synthetisiert wurde.

Beispiel 5

Statt des in Beispiel 1 beschriebenen Polyurethans kann auch in gleicher Menge (2,8 g) ein Polyurethan verwendet werden, das in analoger Weise aus

11 Molen 2,2,4-Trimethyl-hexamethylendiisocyanat und einem Gemisch von
5 Molen Decandiol-(1,10) und
5 Molen Triäthylenglykol (1. Reaktionsstufe) und danach
2 Molen Hydroxyäthylmethacrylat (2. Reaktionsstufe)

synthetisiert wurde.

Beispiel 6

Eine Lösung aus

6,5 g des in Beispiel 1 angegebenen Terpolymerisats,
5,0 g eines ungesättigten Polyurethans, das in analoger Reaktion wie in Beispiel 1 beschrieben aus

3 Molen 2,2,4-Trimethyl-hexamethylendiisocyanat und
2 Molen Triäthylenglykol (1. Reaktionsstufe) und danach
2 Molen Hydroxyäthylmethacrylat (2. Reaktionsstufe)
synthetisiert wurd,
2,8 g 4-Hydroxy-(2-äthylhexyl)-benzoat
0,2 g 9-Phenyl-acridin
0,1 g 3-Mercapto-propionsäure-2,4-dichlor-anilid und
0,025 g des Farbstoffs "Disperse Red" (C. J. 179) in
25 g Methyläthylketon und
2 g Äthanol
wird, wie in Beispiel 1 beschrieben, auf eine Polyesterfolie aufgeschleudert und getrocknet, so daß ein Schichtgewicht von 50 g/m² erhalten wird.

Es wird durch eine Filmvorlage, die Liniengruppen verschiedener Linienbreiten aufweist, mit dem in Beispiel 1 beschriebenen Belichtungsgerät 15 Sekunden belichtet.

Nach 120 Sekunden Entwicklung im Sprühentwicklungsgerät mit 0,8 %iger Sodalösung werden noch Linien der Breite 50 μm aufgelöst. Die Entwicklerresistenz beträgt mindestens das 3- bis 5-fache der normalen Entwicklungszeit.

Die Flexibilität ist auch bei 160 Sekunden Belichtungszeit noch sehr gut.

Die Galvanoresistenzen in den in Beispiel 1 angegebenen Galvanobädern sind sehr gut.

## Beispiel 7

Statt der in Beispiel 6 angegebenen 5,0 g des dort beschriebenen Urethan-Monomeren kann auch eine Mischung aus
2,8 g des in Beispiel 6 beschriebenen polymerisierbaren Polyurethans und
2,8 g eines polymerisierbaren Polyurethans, das aus
11 Molen 2,2,4-Trimethyl-hexamethylendiisocyanat und einer Mischung aus
5 Molen Triäthylenglykol und
5 Molen 2-Äthyl-2-n-butylpropandiol-1,3 (1. Reaktionsstufe) und danach
2 Molen Hydroxyäthylmethacrylat (2. Reaktionsstufe)
in der in Beispiel 1 beschriebenen Weise synthetisiert wurde, verwendet werden.

## Beispiel 8

Statt der in Beispiel 6 angegebenen 5,0 g des dort beschriebenen Urethan-Monomeren können auch 5,6 g eines Urethan-Monomeren verwendet werden, das aus
4 Molen 2,2,4-Trimethyl-hexamethylendiisocyanat und
3 Molen Triäthylenglykol (1. Reaktionsstufe) und danach
2 Molen Hydroxyäthylmethacrylat (2. Reaktionsstufe)
in der in Beispiel 1 beschriebenen Weise synthetisiert wurde.

Aus den Gemischen der Beispiele 7 und 8 werden Trockenresistfolien mit 45 μm dicken photopolymerisierbaren Schichten hergestellt. Die Ergebnisse sind ähnlich wie in Beispiel 6.

## Beispiel 9

Eine Lösung aus
6,5 g des in Beispiel 1 angegebenen Terpolymerisats,
2,8 g des in Beispiel 1 angegebenen polymerisierbaren Diurethans,
0,1 g 3-Mercapto-propionsäure-2,4-dichlor-anilid,
0,2 g 9-Phenyl-acridin,
2,8 g des in Beispiel 6 angegebenen polymerisierbaren Polyurethans,
0,035 g des in Beispiel 1 beschriebenen blauen Farbstoffs und
2,8 g des 3,5-Dihydroxy-benzoesäureesters von Diäthylenglykol-mono-2-äthylhexyläther in
30 g Methyläthylketon und
2 g Äthanol
wurde wie in Beispiel 1 beschrieben zu einer Trockenresistfolie vom Schichtgewicht 30 g/m² verarbeitet.

Nach dem Laminieren bei 120°C auf eine mit Kupfer kaschierte Schichtstoffplatte wurde durch die in Beispiel 6 verwendete Filmvorlage 6 Sekunden mit dem in Beispiel 1 angegebenen Belichtungsgerät belichtet. Nach 45 Sekunden Sprühentwickeln mit 0,8%iger $Na_2CO_3$-Lösung wird ein originalgetreues Abbild der Linien der Vorlage bis zu Linienbreiten von 50 μm erhalten.

Die Flexibilität dieser Schicht ist auch nach 160 Sekunden Belichtungszeit, also nach 25-facher Uberbelichtung, noch sehr gut.

## Beispiel 10 (Vergleichsbeispiel)

Ein Lösung aus
6,5 g des in Beispiel 1 angegebenen Terpolymerisats,
5,6 g des in Beispiel 1 angegebenen polymerisierbaren Diurethans,

2,8 g 4-Hydroxy-(2-äthylhexyl)-benzoat,
0,1 g 3-Mercapto-propionsüre-2,4-dichloranilid,
0,2 g 9-Phenyl-acridin und
0,025 g des Farbstoffes "Disperse Red" (C. J. 179) in
25 g Methyläthylketon und
2 g Äthanol
wurde wie in Beispiel 1 beschrieben zu einer Trockenresistfolie vom Schichtgewicht 52 g/$m^2$ verarbeitet.

Man erhält eine Trockenresistschicht, die eine gute Lichtempfindlichkeit besitzt, jedoch beim Überbelichten zum Verspröden neigt. So ist die Schicht bei einfacher Belichtungszeit (15 Sekunden) noch flexibel; bei doppelter Belichtungszeit, also bei 30 Sekunden und zunehmend ab 40 Sekunden Belichtungszeit mit dem in Beispiel 1 angegebenen Belichtungsgerät wird die Schicht jedoch spröde und läßt sich nicht mehr dehnen, ohne zu reißen und zu splittern. Darüber hinaus neigt die Schicht zum Fließen bei Zimmertemperatur und damit zu störendem Randaustritt bei Trockenresistrollen, z. B. mit einer Wickellänge von 50 m. Eine Schicht, die anstelle des Diurethans 5,0 g des in Beispiel 6 angegebenen polymerisierbaren Polyurethans enthält, zeigt keinen störenden Randaustritt der Resistrollen beim Lagern, was auf den wesentlich geringeren Kaltfluß zurückgeführt werden kann. Sie ist auch bei 10-facher Überbelichtung noch flexibel.

In den folgenden Tabellen sind Viskositäten von bekannten polymerisierbaren Urethanen und von solchen gemäß der Erfindung entweder in 80%iger Lösung in Toluol (Tabelle A) oder in lösungsmittelfreiem Zustand (Tabelle B) angegeben. Mit dem Viskositätsanstieg ist jeweils eine entsprechende Abnahme des Kaltflusses der Schichten verbunden, die die angegebenen Monomeren in der Mischung von Beispiel 10 enthalten.

TABELLE A

| Zusammensetzung des Monomeren (Ausgangsstoffe in Molen) | | | mittleres Molekulargewicht (errechnet aus eingesetzter Molzahl) | Viskosität in Toluol, 80 Gew.-% bei 23°C mPa.s |
|---|---|---|---|---|
| TMDI ¹) | Triäthylenglykol | HEMA ²) | | |
| *2 | 1 | 2 | 830 | 1410 |
| 3 | 2 | 2 | 1190 | 3900 |
| 4 | 3 | 2 | 1550 | 8930 |
| 5 | 4 | 2 | 1910 | 12750 |
| 7 | 6 | 2 | 2630 | 13400 |

1) TMDI = 2,2,4-Trimethyl-hexamethylendiisocyanat

2) HEMA = Hydroxyathylmethacrylat

* DE-OS 23 61 041

TABELLE B

| Monomeres bzw. Monomerengemisch | Viskosität bei 23° C, mPa.s |
|---|---|
| Diurethan von Beispiel 1 (nach DE-OS 20 64 079) 1 TMDI + 2 HEMA | 10 700 |
| Tetraurethan nach DE-OS 23 61 041 2 TMDI + 1 Triäthylenglykol + 2 HEMA | 183 400 |
| Mischung aus 50% Tetraurethan nach OS 23 61 041 und 50% Polyurethan aus 4 TMDI + 3 Triäthylenglykol + 2 HEMA | 802 300 |
| Mischung aus 50% Diurethan nach Beispiel 1 50% Polyurethan aus 11 TMDI + 10 Triäthylenglykol + 2 HEMA | 3 772 000 |

Der Kaltfluß von Schichten, die diese Monomeren enthalten, nimmt wiederum entsprechend dem Viskositätsanstieg ab.

Mit steigender Viskosität der verwendeten Monomeren nimmt auch die Flexibilität der Schichten nach der Belichtung bzw. Überbelichtung zu. Die Haftung der belichteten Schichten auf Kupfer sowie ihre Entwickler- und Galvanoresistenz bleiben im wesentlichen gleich.

Beispiel 11 (Vergleichsbeispiel)

Verwendet man in der in Beispiel 10 beschriebenen Mischung anstelle des dort angegebenen polymerisierbaren Diurethans die gleiche Menge (5,6 g) eines Tetraurethans, das aus
2 Molen 2,2,4-Trimethyl-hexamethylendiisocyanat und
1 Mol Polyäthylenglykol mit dem mittleren Molgewicht 400 (1. Reaktionsstufe) und danach
2 Molen Hydroxyäthylmethacrylat (2. Reaktionsstufe)
hergestellt wurde und verarbeitet das Gemisch in gleicher Weise wie in Beispiel 1 zu einer Trockenresistfolie mit 52 g/m² Schichtgewicht, so erhält man nach der in Beispiel 1 angegeben Weiterverarbeitung eine Resistschablone, bei der in dem Kupferbad das Kupferrest in einem Abstand um etwa 50 µm von der Resistkante abgeschieden wird. Das bedeutet, daß z.B. auf Leiterbahnen von weniger als 100 µm Breite überkaupt kein Kupfer abgeschieden wird.

**Patentansprüche**

1. Photopolymerisierbares Gemisch, enthaltend ein polymeres, in wäßrig-alkalischen Lösungen lösliches oder quellbares Bindemittel, einen Photoinitiator und ein zur Additionspolymerisation befähigtes Polyurethan mit zwei endständigen Acryl- oder Methacrylsäureestergruppen, dadurch gekennzeichnet, daß das Gemisch ein Polyurethan der Formel I

$$CH_2=\underset{\underset{R_1}{|}}{C}-COO-Z-CONH-Y-(NHCOO-X-CONH-Y-)_nNHCOO-Z-CO-\underset{\underset{R_1}{|}}{C}=CH_2 \qquad (I)$$

enthält, worin

—X— eine der Gruppen

$$(-CH_2-\underset{\underset{R_2}{|}}{CH}-O)_m-,\quad (-CH_2-\underset{\underset{R_2}{|}}{CH}-S-)_{m-1}CH_2\underset{\underset{R_2}{|}}{CH}-O-,\quad -C_kH_{2k}-O-\ \text{und}\ -C_rH_{2r-2}-O-,$$

Y ein gesättigter aliphatischer oder cycloaliphatischer Rest mit 2 bis 12 Kohlenstoffatomen,

Z

$$(-CH_2-\underset{\substack{|\\R_3}}{CH}-O)_p,$$

$R_1$, $R_2$ und $R_3$ Wasserstoffatome oder Methylgruppen,
n eine Zahl von 2 bis 15,
m eine Zahl von 2 bis 4,
p eine Zahl von 1 bis 4,
k eine Zahl von 2 bis 12,
r eine Zahl von 4 bis 12
ist.

2. Photopolymerisierbares Gemisch nach Anspruch 1, dadurch gekennzeichnet, daß es eine Verbindung der Formel I enthält, worin n eine Zahl von 2 bis 11 ist.

3. Photopolymerisierbares Gemisch nach Anspruch 1, dadurch gekennzeichnet, daß es eine Verbindung der Formel I enthält, worin $R_1$ eine Methylgruppe ist.

4. Photopolymerisierbares Gemisch nach Anspruch 1, dadurch gekennzeichnet, daß es eine Verbindung der Formel I enthält, worin X die Gruppe

$$(-CH_2-\underset{\substack{|\\R_2}}{CH}-O)_m-$$

bedeutet.

5. Photopolymerisierbares Gemisch nach Anspruch 4, dadurch gekennzeichnet, daß es eine Verbindung der Formel I enthält, worin $R_2$ ein Wasserstoffatom ist.

6. Photopolymerisierbares Gemisch nach Anspruch 4, dadurch gekennzeichnet, daß es eine Verbindung der Formel I enthält, worin $m = 3$ und $R_2$ ein Wasserstoffatom ist.

7. Photopolymerisierbares Gemisch nach Anspruch 1, dadurch gekennzeichnet, daß es eine Verbindung der Formel I enthält, worin $R_3$ ein Wasserstoffatom und $p = 1$ ist.

8. Photopolymerisierbares Gemisch nach Anspruch 1, dadurch gekennzeichnet, daß es eine Verbindung der Formel I enthält, worin Y ein gesättigter aliphatischer Rest mit mindestens einer seitenständigen Methylgruppe ist.

9. Photopolymerisierbares Gemisch nach Anspruch 1, dadurch gekennzeichnet, daß es 10 bis 60 Gew.-%, bezogen auf seine nichtflüchtigen Bestandteile, an Verbindungen der Formel I enthält.

10. Photopolymerisierbares Gemisch nach Anspruch 1, dadurch gekennzeichnet, daß das Bindemittel ein Mischpolymerisat der Acryl- oder Methacrylsäure mit einer Säurezahl von 50 bis 250 ist.

11. Photopolymerisierbares Gemisch nach Anspruch 10, dadurch gekennzeichnet, daß das Mischpolymerisat ein Terpolymerisat aus Methacrylsäure, einem Alkylmethacrylat mit 4 bis 15 C-Atomen in der Alkylgruppe und einem weiteren, damit mischpolymerisierbaren Monomeren ist, dessen zugehöriges Homopolymerisat eine Glastemperatur von mindestens 80°C aufweist.

12. Lichtempfindliches Schichtübertragungsmaterial aus einem temporären flexiblen Schichtträger, einer thermoplastischen photopolymerisierbaren Schicht, die ein polymeres, thermoplastisches, in wäßrig-alkalischen Lösungen lösliches oder quellbares Bindemittel, ein zur Additionspolymerisation befähigtes Polyurethan mit zwei endständigen Acryl- oder Methacrylsäureestergruppen und einen Photoinitiator enthält, und gegebenenfalls einem abziehbaren Deckblatt auf der dem Schichtträger abgewandten Seite der Schicht, dadurch gekennzeichnet, daß die Schicht ein Polyurethan der Formel I

$$CH_2=\underset{\substack{|\\R_1}}{C}-COO-Z-CONH-Y-(NHCOO-X-CONH-Y-)_nNHCOO-Z-CO-\underset{\substack{|\\R_1}}{C}=CH_2 \quad (I)$$

enthält, worin

—X— eine der Gruppen

$$(-CH_2-\underset{\substack{|\\R_2}}{CH}-O)_m-,\ (-CH_2-\underset{\substack{|\\R_2}}{CH}-S-)_{m-1}CH_2\underset{\substack{|\\R_2}}{CH}-O-,\ -C_kH_{2k}-O-\ \text{und}\ -C_rH_{2r-2}-O-,$$

Y ein gesättigter aliphatischer oder cycloaliphatischer Rest mit 2 bis 12 Kohlenstoffatomen,
Z

$$(-CH_2-\underset{\substack{|\\R_3}}{CH}-O)_p,$$

$R_1$, $R_2$ und $R_3$ Wasserstoffatome oder Methylgruppen,
n eine Zahl von 2 bis 15,
m eine Zahl von 2 bis 4,
p eine Zahl von 1 bis 4,
k eine Zahl von 2 bis 12,
r eine Zahl von 4 bis 12
ist.

## Revendications

1. Mélange photopolymérisable contenant un liant polymère soluble ou pouvant gonfler dans des solutions alcalines aqueuses, un photo-amorceur et un polyuréthanne susceptible de polymérisation par addition et contenant deux groupes ester acrylique ou méthacrylique terminaux, caractérisé en ce que le mélange contient un polyuréthanne de la formule I

$$CH_2 = \underset{R_1}{C}—COO—Z—CONH—Y—(NHCOO—X—CONH—Y—)_nNHCOO—Z—CO—\underset{R_1}{C}=CH_2$$

dans laquelle:
—X— est l'un des groupes:

$$(—CH_2—\underset{R_2}{CH}—O)_m— ,\quad (—CH_2—\underset{R_2}{CH}—S—)_{m-1}\,CH_2\underset{R_2}{CH}—O— ,\quad —C_kH_{2k}—O— \text{ et } —C_rH_{2r-2}—O— ,$$

Y est un radical aliphatique ou cyclo-aliphatique saturé contenant de 2 à 12 atomes de carbone,
Z est

$$(—CH_2—\underset{R_3}{CH}—O)_p—$$

$R_1$, $R_2$ et $R_3$ sont des atomes d'hydrogène ou des groupes méthyle,
n est un nombre de 2 à 15,
m un nombre de 2 à 4,
p un nombre de 1 à 4,
k un nombre de 2 à 12,
r un nombre de 4 à 12.

2. Mélange photopolymérisable selon la revendication 1, caractérisé en ce qu'il contient un composé de formule I dans lequel n est un nombre compris entre 2 et 11.

3. Mélange photopolymérisable selon la revendication 1, caractérisé en ce qu'il contient un composé de formule I dans lequel $R_1$ est un groupe méthyle.

4. Mélange photopolymérisable selon la revendication 1, caractérisé en ce qu'il contient un composé de formule I dans lequel X représente le groupe

$$(—CH_2—\underset{R_2}{CH}—O)_m— ,$$

5. Mélange photopolymérisable selon la revendication 4, caractérisé en ce qu'il contient un composé de formule I dans lequel $R_2$ est un atome d'hydrogène.

6. Mélange photopolymérisable selon la revendication 4, caractérisé en ce qu'il contient un composé de formule I dans lequel $m = 3$ et $R_2$ est un atome d'hydrogène.

7. Mélange photopolymérisable selon la revendication 1, caractérisé en ce qu'il contient un composé de formule I dans lequel $R_3$ est un atome d'hydrogène et $p = 1$.

8. Mélange photopolymérisable selon la revendication 1, caractérisé en ce qu'il contient un composé de formule I dans lequel Y est un radical aliphatique saturé contenant au moins un groupe méthyle latéral.

9. Mélange photopolymérisable selon la revendication 1, caractérisé en ce qu'il contient entre 10 et 60% en poids de composés de formule I relativement à ses constituants non volatils.

10. Mélange photopolymérisable selon la revendication 1, caractérisé en ce que le liant est un produit de copolymérisation d'acide acrylique ou méthacrylique ayant un indice d'acide compris entre 50 et 250.

11. Mélange photopolymérisable selon la revendication 10, caractérisé en ce que le produit de copolymérisation est un produit de terpolymérisation d'acide méthacrylique, d'un méthacrylate d'alkyle contenant de 4 à 15 atomes de carbone dans le groupe alkyle et d'un autre monomère copolymérisable avec ceux-ci, dont le produit d'homopolymérisation correspondant présente une température de transition vitreuse d'au moins 80°C.

12. Matière photosensible de transfert de couche formée d'un support de couche flexible temporaire, d'une couche photopolymérisable thermoplastique qui contient un liant polymère thermoplastique soluble ou pouvant gonfler dans des solutions alcalines aqueuses, un polyuréthanne susceptible de polymérisation par addition et contenant deux groupes ester acrylique ou méthacrylique terminaux et un photoamorceur, et éventuellement d'une feuille de recouvrement détachable sur le côté de la couche qui est opposé au support de couche, caractérisé en ce que la couche contient un polyuréthanne de la formule I

$$CH_2=\underset{\displaystyle R_1}{\underset{|}{C}}-COO-Z-CONH-Y-(NHCOO-X-CONH-Y-)_nNHCOO-Z-CO-\underset{\displaystyle R_1}{\underset{|}{C}}=CH_2 \quad (I)$$

dans laquelle:

—X— est l'un des groupes:

$$(-CH_2-\underset{\displaystyle R_2}{\underset{|}{CH}}-O)_m-,\quad (-CH_2-\underset{\displaystyle R_2}{\underset{|}{CH}}-S-)_{m-1}\,CH_2\underset{\displaystyle R_2}{\underset{|}{CH}}-O-,\quad -C_kH_{2k}-O-\ \text{et}\ -C_rH_{2r-2}-O-,$$

Y est un radical aliphatique ou cyclo-aliphatique saturé contenant de 2 à 12 atomes de carbone, Z est

$$(-CH_2-\underset{\displaystyle R_3}{\underset{|}{CH}}-O)_p$$

$R_1$, $R_2$ et $R_3$ sont des atomes d'hydrogène ou des groupes méthyle,
n est un nombre de 2 à 15,
m un nombre de 2 à 4,
p un nombre de 1 à 4,
k un nombre de 2 à 12,
r un nombre de 4 à 12.

**Claims**

1. A photopolymerizable mixture comprising a polymeric binder which is soluble or at least swellable in aqueous alkaline solutions, a photoinitiator, and a polyurethane with two terminal acrylic acid or methacrylic acid ester groups which is capable of addition polymerization, characterized in that the mixture contains a polyurethane corresponding to the following general Formula I

$$CH_2=\underset{\displaystyle R_1}{\underset{|}{C}}-COO-Z-CONH-Y-(NHCOO-X-CONH-Y-)_nNHCOO-Z-CO-\underset{\displaystyle R_1}{\underset{|}{C}}=CH_2 \quad (I)$$

wherein

—X— is one of the groups

$$(-CH_2-\underset{\displaystyle R_2}{\underset{|}{CH}}-O)_m-,\quad (-CH_2-\underset{\displaystyle R_2}{\underset{|}{CH}}-S-)_{m-1}\,CH_2\underset{\displaystyle R_2}{\underset{|}{CH}}-O-,\quad -C_kH_{2k}-O-\ \text{and}\ -C_rH_{2r-2}-O-,$$

Y is a saturated aliphatic or cycloaliphatic group with 2 to 12 carbon atoms, and Z is

$$(-CH_2-\underset{\displaystyle R_3}{\underset{|}{CH}}-O)_p$$

and wherein

$R_1$, $R_2$, and $R_3$ are hydrogen atoms or methyl groups,

n is a whole number between 2 and 15,
m is a whole number between 2 and 4,
p is a whole number between 1 and 4,
k is a whole number between 2 and 12, and
r is a whole number between 4 and 12.

2. A photopolymerizable mixture according to claim 1, characterized in that it contains a compound corresponding to Formula I wherein n is a whole number from 2 to 11.

3. A photopolymerizable mixture according to claim 1, characterized in that it contains a compound corresponding to Formula I wherein $R_1$ is a methyl group.

4. A photopolymerizable mixture according to claim 1, characterized in that it contains a compound corresponding to Formula I wherein X is the group

$$(-CH_2-\underset{\displaystyle R_2}{\underset{|}{CH}}-O)_m-$$

5. A photopolymerizable mixture according to claim 4, characterized in that it contains a compound corresponding to Formula I wherein $R_2$ is a hydrogen atom.

6. A photopolymerizable mixture according to claim 4, characterized in that it contains a compound corresponding to Formula I wherein $m = 3$ and $R_2$ is a hydrogen atom.

7. A photopolymerizable mixture according to claim 1, characterized in that it contains a compound corresponding to Formula I wherein $R_3$ is a hydrogen atom and $p = 1$.

8. A photopolymerizable mixture according to claim 1, characterized in that it contains a compound corresponding to Formula I wherein Y is a saturated aliphatic group with at least one lateral methyl group.

9. A photopolymerizable mixture according to claim 1, characterized in that it contains from 10 to 60 per cent by weight, calculated on its non-volatile components, of compounds corresponding to Formula I.

10. A photopolymerizable mixture according to claim 1, characterized in that the binder is an acrylic acid or methacrylic acid copolymer with an acid number between 50 and 250.

11. A photopolymerizable mixture according to claim 10, characterized in that the copolymer is a terpolymer obtained from methacrylic acid, an alkyl methacrylate with 4 to 15 carbon atoms in the alkyl group, and a further monomer which can be copolymerized with the first two components and whose homopolymer has a glass transition temperature of at least 80°C.

12. A light-sensitive transfer material, comprising a flexible temporary support and a thermoplastic photopolymerizable layer which comprises a polymeric, thermoplastic binder which is soluble or at least swellable in aqueous-alkaline solutions, a polyurethane with two terminal acrylic acid or methacrylic acid ester groups which is capable of addition polymerization, and a photoinitiator, and possibly further comprising a peelable cover film on the surface of the layer remote from the support, characterized in that the layer contains a polyurethane corresponding to Formula I

$$CH_2=\underset{\displaystyle R_1}{\underset{|}{C}}-COO-Z-CONH-Y-(NHCOO-X-CONH-Y-)_nNHCOO-Z-CO-\underset{\displaystyle R_1}{\underset{|}{C}}=CH_2 \qquad (I)$$

wherein
—X— is one of the groups

$$(-CH_2-\underset{\displaystyle R_2}{\underset{|}{CH}}-O)_m-,\quad (-CH_2-\underset{\displaystyle R_2}{\underset{|}{CH}}-S-)_{m-1}CH_2\underset{\displaystyle R_2}{\underset{|}{CH}}-O-,\quad -C_kH_{2k}-O-\ \text{and}\ -C_rH_{2r-2}-O-,$$

Y is a saturated aliphatic or cycloaliphatic group with 2 to 12 carbon atoms, and
Z is

$$(-CH_2-\underset{\displaystyle R_3}{\underset{|}{CH}}-O)_p$$

and wherein
$R_1$, $R_2$, and $R_3$ are hydrogen atoms or methyl groups,
n is a whole number between 2 and 15,
m is a whole number between 2 and 4,
p is a whole number between 1 and 4,
k is a whole number between 2 and 12, and
r is a whole number between 4 and 12.